# EUROPÄISCHE PATENTSCHRIFT

(11) **EP 2 633 182 B1**
(45) Veröffentlichungstag und Bekanntmachung des Hinweises auf die Patenterteilung: **30.05.2018**
(21) Anmeldenummer: 11757256.0
(22) Anmeldetag: 08.09.2011
(51) Int. Cl.: F02P 23/04, H01S 5/183

(54) **LASERZÜNDKERZE FÜR EINE BRENNKRAFTMASCHINE UND BETRIEBSVERFAHREN HIERFÜR**
LASER IGNITION PLUG FOR AN INTERNAL COMBUSTION ENGINE AND OPERATING METHOD FOR THE SAME
BOUGIE D'ALLUMAGE LASER POUR UN MOTEUR À COMBUSTION INTERNE ET SON PROCÉDÉ DE FONCTIONNEMENT

(30) Priorität: 26.10.2010 DE 102010042909
(43) Veröffentlichungstag der Anmeldung: 04.09.2013
(73) Patentinhaber: Robert Bosch GmbH, 70442 Stuttgart (DE)
(72) Erfinder: HARTKE, Rene, 70178 Stuttgart (DE); RIDDERBUSCH, Heiko, 71701 Schwieberdingen (DE)
(86) Internationale Anmeldenummer: PCT/EP2011/065570
(87) Internationale Veröffentlichungsnummer: WO 2012/055626

(56) Entgegenhaltungen:
- WO-A1-95/28756
- WO-A1-2005/066488
- WO-A2-2007/071794
- DE-A1-102004 007 881
- DE-A1-102007 053 414
- US-A- 5 812 571

## Beschreibung

### Stand der Technik

Die Erfindung betrifft eine Laserzündkerze für eine Brennkraftmaschine, mit einer Lasereinrichtung zur Erzeugung von Laserimpulsen.

Die Erfindung betrifft ferner ein Verfahren zum Betreiben einer derartigen Laserzündkerze.

Es ist bereits bekannt, passiv gütegeschaltete Lasereinrichtungen für Laserzündkerzen von Brennkraftmaschinen einzusetzen. Die passiv gütegeschalteten Lasersysteme weisen den Nachteil auf, dass sie eine verhältnismäßig aufwendige Konstruktion der Laserzündkerze erfordern und hohe Herstellungskosten bedingen. Die WO 2005/066488 A1 zeigt eine solche Anordnung. Offenbarung der Erfindung Demgemäß ist es Aufgabe der vorliegenden Erfindung, eine Laserzündkerze und ein Verfahren zum Betreiben einer Laserzündkerze der eingangs genannten Art dahingehend zu verbessern, dass ein Aufbau mit geringerer Komplexität und überdies geringere Fertigungskosten erzielt werden.

Diese Aufgabe wird bei der Laserzündkerze der eingangs genannten Art erfindungsgemäß dadurch gelöst, dass die Lasereinrichtung eine Mehrzahl von oberflächenemittierenden Halbleiterlasern zur Erzeugung der Laserimpulse aufweist. Die oberflächenemittierenden Halbleiterlaser, englisch auch als vertical cavity surface emitting laser (VCSEL) bezeichnet, besitzen gegenüber herkömmlichen gütegeschalteten Lasersystemen mit einem laseraktiven Festkörper den bedeutenden Vorteil, dass sie sehr klein bauen und eine geringere Temperaturempfindlichkeit aufweisen. Die erfindungsgemäß vorgesehene Mehrzahl von VCSEL-Halbleiterlasern wird nachfolgend auch als VCSEL-Array bezeichnet.

Neben einem vereinfachten Aufbau der Laserzündkerze ergeben sich durch den erfindungsgemäßen Einsatz von oberflächenemittierenden Halbleiterlasern auch signifikante Kostensenkungen, da die Herstellungskosten für Halbleiterlaser wie beispielsweise die oberflächenemittierenden Halbleiterlaser erwartungsgemäß stärker mit der Stückzahl abnehmen als die Kosten für Festkörperlaser und weitere optische Elemente, die für den Betrieb von Festkörperlasern erforderlich sind. Es ist vorgesehen, dass die Lasereinrichtung in die Laserzündkerze integriert ist, und dass die Lasereinrichtung hermetisch gekapselt ist, wodurch vorteilhaft nicht ein gesamter Innenraum eines Gehäuses der Laserzündkerze hermetisch abgedichtet werden muss. Vielmehr kann durch die hermetische Kapselung der Lasereinrichtung selbst eine weniger aufwendig und damit kostengünstigere Abdichtung des Laserzündkerzengehäuses vorgenommen werden. Gleichzeitig ist durch die hermetische Abdichtung der Lasereinrichtung sichergestellt, dass die Halbleiterlaser dennoch vor in das Laserzündkerzengehäuse möglicherweise eindringenden Partikeln geschützt sind.

Bei einer weiteren vorteilhaften Ausführungsform ist vorgesehen, dass die Lasereinrichtung dazu ausgebildet ist, Laserimpulse mit einer Wellenlänge von etwa 400 Nanometer bis etwa 2500 Nanometer zu erzeugen, wodurch es vorteilhaft möglich ist, die Wellenlänge des Halbleiterlasers auf Absorptionslinien in einem zu zündenden Luft-/Kraftstoffgemisch einzustellen. Beispielsweise kann ein Methan enthaltendes Gemisch effizient mittels Wellenlängen von etwa 1,33 µm (Mikrometer) und/oder etwa 1,65 µm gezündet werden. Dadurch sinkt vorteilhaft der Bedarf an optischer Impulsenergie für die Laserzündimpulse, weil die Absorption und somit die Effizienz des Energieeintrags der Laserzündimpulse in das Gemisch steigt. Bei den erfindungsgemäß vorgeschlagenen oberflächenemittierenden Halbleiterlasern kann die Wellenlänge der zu emittierenden Laserimpulse - im Gegensatz zu herkömmlichen passiv gütegeschalteten Festkörperlasern - in weiten Grenzen eingestellt werden, so dass eine effiziente Anpassung der erfindungsgemäß erzeugten Laserimpulse an das zu verbrennende Gemisch möglich ist.
Bei einer weiteren vorteilhaften Ausführungsform ist vorgesehen, dass die Lasereinrichtung Mittel zu Phasenkopplung einzelner Halbleiterlaser aufweist, wodurch eine hohe Kohärenz der von der erfindungsgemäßen Laserzündkerze erzeugten Laserimpulse erzielbar ist. Die Mittel zur Phasenkopplung können beispielsweise einen Referenz-Halbleiterlaser aufweisen, der so ausgebildet und/oder angeordnet ist, dass die von ihm erzeugte Strahlung weitere Halbleiterlaser der erfindungsgemäßen Lasereinrichtung beaufschlagt, wodurch sich diese in an sich bekannter Weise auf die Phase des Referenzlasers synchronisieren. Ein derartiger Referenz-Halbleiterlaser wird auch als Seed-Laser bezeichnet. Bevorzugt ist der Seed-Laser so angeordnet, dass die von ihm erzeugte Laserstrahlung auf alle oberflächenemittierenden Halbleiterlaser der Lasereinrichtung eingestrahlt werden kann, um eine maximale Synchronität der beteiligten oberflächenemittierenden Halbleiterlaser sicherzustellen. Die Strahlung des Seed-Lasers sorgt in an sich bekannter Weise für eine Phasenkopplung der einzelnen Emitter des VCSEL-Arrays.

Bei einer weiteren vorteilhaften Ausführungsform ist vorgesehen, dass eine Mehrzahl von oberflächenemittieren Halbleiterlasern der Lasereinrichtung in einer im wesentlichen ebenen Konfiguration angeordnet ist. Dadurch ist eine besonders effiziente Einkopplung der von den oberflächenemittierenden Halbleiterlasern erzeugten Laserstrahlung in den Brennraum der Brennkraftmaschine möglich, beispielsweise unter Verwendung einer im Strahlengang angeordneten Fokussieroptik, beispielsweise einer Fokussierlinse, die zum Beispiel auch gleichzeitig als Brennraumfenster dienen kann.

Bei einer weiteren sehr vorteilhaften Ausführungsform ist vorgesehen, dass mehrere Gruppen ("Arrays") von oberflächenemittierenden Halbleiterlasern vorgesehen sind, und dass Mittel zur Überlagerung der von den einzelnen Gruppen erzeugten Laserstrahlung vorgesehen sind, wodurch eine weitere Steigerung der Leistung der Laserzündimpulse möglich ist. Beispielsweise kann mittels an sich bekannter Umstapeltechniken unter Verwendung von Stufenspiegeln die Strahlung mehrerer VCSEL-Arrays, also der mehreren Gruppen von oberflächenemittierenden Halbleiterlasern, überlagert werden, wodurch sich eine höhere Leistungsdichte ergibt. Insbesondere können beispielsweise einzelne oberflächenemittierende Halbleiterlaser mit unterschiedlicher Wellenlänge und/oder Polarisation vorgesehen sein, deren Strahlung durch dichroitische oder polarisationsabhängige optische Elemente oder eine Kombination hieraus überlagert wird. Auf diese Weise lassen sich deutlich höhere Strahldichten erzielen. Bei dieser Ausführungsform ist darauf zu achten, dass eine die Laserimpulse in den Brennraum bündelnde Fokussieroptik entsprechend breitbanding bzw. für die verwendeten Polarisationen ausgelegt ist.

Bei einer weiteren vorteilhaften Ausführungsform ist vorgesehen, dass ein optischer Verstärker zur optischen Verstärkung der von der Lasereinrichtung erzeugten Laserimpulse vorgesehen ist, und dass eine Pumplichtquelle zum optischen Pumpen des optischen Verstärkers vorgesehen ist. Unter Verwendung der Pumplichtquelle kann in an sich bekannter Weise der optische Verstärker optisch gepumpt werden, um darin eine Besetzungsinversion aufzubauen, die bei der Emission des Laserimpulses mittels der erfindungsgemäßen Lasereinrichtung abgebaut wird, um den Laserimpuls in an sich bekannter Weise optisch zu verstärken.

Bei einer weiteren bevorzugten Ausführungsform ist vorgesehen, dass die Pumplichtquelle mindestens einen Halbleiterlaser aufweist, insbesondere eine Mehrzahl von oberflächenemittierenden Halbleiterlasern. Das bedeutet, bei dieser Ausführungsform wird sowohl der für die Laserzündung verwendete, optisch zu verstärkende Laserimpuls als auch die zum optischen Pumpen des optischen Verstärkers verwendete Laserstrahlung jeweils von einer Gruppe von oberflächenemittierenden Halbleiterlasern bzw. mehreren VCSEL-Arrays geliefert. Die verschiedenen VCSEL-Arrays können einer weiteren vorteilhaften Ausführungsform zufolge bevorzugt auch auf einer gemeinsamen Wärmesenke angeordnet sein.

Bei noch einer weiteren vorteilhaften Ausführungsform ist vorgesehen, dass die Pumplichtquelle in die Laserzündkerze integriert ist, und dass eine Einkoppeloptik vorgesehen ist, um die Laserimpulse der Lasereinrichtung und von der Pumplichtquelle erzeugte Pumpstrahlung longitudinal in den optischen Verstärker einzukoppeln, wodurch sich eine besonders gute räumliche Überlappung zwischen dem Pumpvolumen in dem optischen Verstärker und dem zu verstärkenden Laserimpuls ergibt, was zu einer effizienten optischen Verstärkung führt.

Eine transversale Einkopplung von Pumpstrahlung in den optischen Verstärker ist alternativ oder ergänzend ebenfalls möglich, wobei wiederum vorteilhaft oberflächenemittierende Halbleiterlaser zur Ausbildung der Pumplichtquelle für das transversale Pumpen verwendet werden können. Die Kombination von longitudinalem und transversalem Pumpen ist ebenfalls möglich.

Das erfindungsgemäße Prinzip ist nicht auf den Einsatz von oberflächenemittierenden Halbleiterlasern zur Erzeugung des Pumplichts für optischen Verstärker begrenzt, sondern es können vielmehr auch andere Halbleiterlaser (zum Beispiel Kantenemitter) zur Bereitstellung des Pumplichts für den optischen Verstärker verwendet werden.

Als eine weitere Lösung der Aufgabe der vorliegenden Erfindung ist ein Verfahren gemäß Patentanspruch 12 angegeben. Das Verfahren sieht vor, dass die Lasereinrichtung eine Mehrzahl von oberflächenemittierenden Halbleiterlasern zur Erzeugung der Laserimpulse aufweist und dass die Lasereinrichtung so angesteuert wird, dass sie innerhalb eines Arbeitszyklus eines Zylinders der Brennkraftmaschine mindestens einen Laserimpuls mit einer Impulsdauer von 100 ns (Nanosekunden) oder weniger, vorzugsweise von 20 ns oder weniger, erzeugt.

Bei einer weiteren bevorzugten Ausführungsform ist vorgesehen, dass die Lasereinrichtung mit einem Puls-Pausenverhältnis von kleiner etwa 1:100, vorzugsweise kleiner etwa 1:1000, betrieben wird, wodurch Untersuchungen der Anmelderin zufolge deutlich höhere Impulsleistungen der oberflächenemittierenden Halbleiterlaser erzielbar sind. Insbesondere erwärmen sich die oberflächenemittierenden Halbleiterlaser für Betriebsdauern unter einer Mikrosekunde und Puls-Pausen-Verhältnissen unter einem Promill nur wenig und können daher mit wesentlich höheren Strömen betrieben werden als bei größeren Puls-Pausen-Verhältnissen. Die Pulsdauern können bevorzugt kleiner 10 ns betragen.

Bei einer weiteren bevorzugten Ausführungsform ist vorgesehen, dass innerhalb eines Arbeitszyklus mehrere Laserimpulse, besonders bevorzugt zwischen etwa 10 Stück und etwa 1000 Stück, mit einer maximalen Impulsdauer von je etwa 20 ns und einer minimalen Impulsenergie von je etwa 0,1 mJ (Millijoule) erzeugt werden, wodurch ein besonders zuverlässiges Zünden des Luft-/Kraftstoffgemischs gegeben ist. Impulsenergien von etwa 0,1 mJ bis etwa 10 mJ sind besonders bevorzugt.

Besonders bevorzugt wird die Mehrzahl von oberflächenemittierenden Halbleiterlasern der Lasereinrichtung zur Erzeugung der Laserimpulse phasengekoppelt betrieben, wodurch eine größtmögliche Kohärenz der erzeugten Laserimpulse und damit eine zuverlässige Entzündung des zu zündenden Luft-/Kraftstoffgemischs gewährleistet ist.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung beziehungsweise Darstellung in der Beschreibung beziehungsweise in der Zeichnung.

### In der Zeichnung zeigt:

- Figur 1: Eine Brennkraftmaschine mit einer erfindungsgemäßen Laserzündkerze,
- Figur 2: schematisch eine erste Ausführungsform der erfindungsgemäßen Laserzündkerze aus Figur 1 im Detail, und
- Figur 3: eine weitere Ausführungsform der erfindungsgemäßen Laserzündkerze.

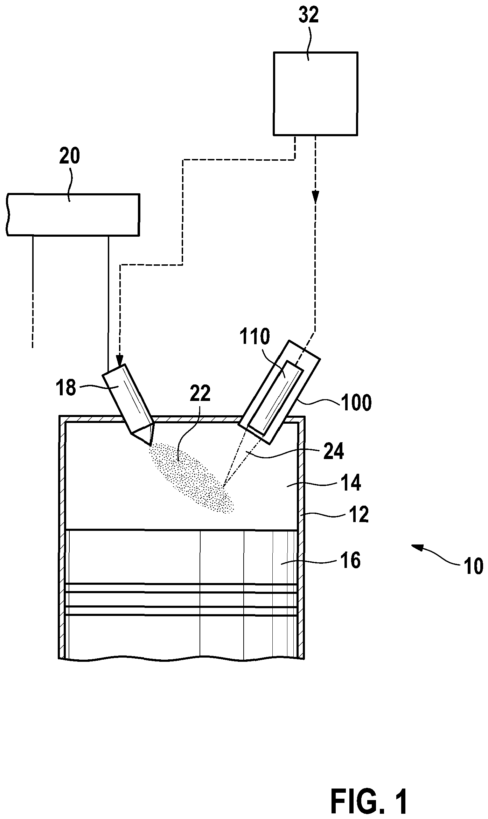

Eine Brennkraftmaschine trägt in Figur 1 insgesamt das Bezugszeichen 10. Sie dient zum Antrieb eines nicht dargestellten Kraftfahrzeugs. Die Brennkraftmaschine 10 umfasst mehrere Zylinder, von denen in Figur 1 nur einer mit dem Bezugszeichen 12 bezeichnet ist. Ein Brennraum 14 des Zylinders 12 wird von einem Kolben 16 begrenzt. Kraftstoff gelangt in den Brennraum 14 direkt durch einen Injektor 18, der an einen auch als Rail bezeichneten Kraftstoff-Druckspeicher 20 angeschlossen ist.

In den Brennraum 14 eingespritzter Kraftstoff 22 wird mittels eines Laserstrahls 24 entzündet, der vorzugsweise in Form eines Laserimpulses 24 von einer eine Lasereinrichtung 110 aufweisenden Laserzündkerze 100 in den Brennraum 14 abgestrahlt wird. Hierzu wird die Lasereinrichtung 110 von einem Steuergerät 32 gesteuert, das auch den Injektor 18 ansteuert.

Erfindungsgemäß weist die Lasereinrichtung 110 der Laserzündkerze 100 eine Mehrzahl von oberflächenemittierenden Halbleiterlasern zur Erzeugung der Laserimpulse 24 auf.

Die Mehrzahl der oberflächenemittierenden Halbleiterlaser, die auch als VCSEL-Array bezeichnet werden, weisen gegenüber herkömmlichen passiv gütegeschalteten Festkörperlasersystemen bedeutetende Vorteile auf. Einerseits sind solche VCSEL-Arrays sehr kleinbauend, wodurch sich die Konstruktion der Laserzündkerze 100 stark vereinfacht. Darüberhinaus weisen VCSEL-Arrays verhältnismäßig geringe Fertigungskosten auf.

Zusätzlich zu dem VCSEL-Array der Lasereinrichtung 110 verfügt die Laserzündkerze 100 in an sich bekannter Weise über eine Fokusieroptik 26, über die die von dem VCSEL-Array der Lasereinrichtung 110 erzeugte Laserstrahlung 24 auf einen in dem Brennraum 14 liegenden und nicht näher bezeichneten Zündpunkt fokussiert wird.

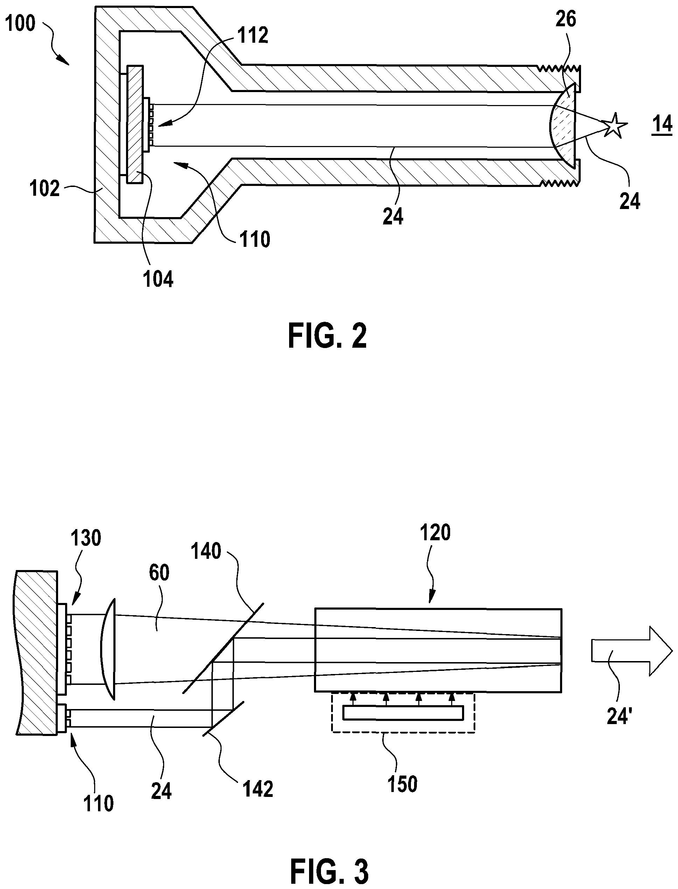

Bei einer bevorzugten Ausführungsform ist die Lasereinrichtung 110 wie in Figur 2 abgebildet direkt in das Gehäuse 102 der Laserzündkerze 100 integriert. Besonders vorteilhaft ist die Lasereinrichtung 110 zusätzlich hermetisch gekapselt, wodurch die Abdichtung des restlichen Laserzündkerzengehäuses 102, insbesondere in dem Bereich der Fokusieroptik 26, die gleichzeitig ein Brennraumfenster darstellt, einfacher ausgebildet sein kann als bei solchen Systemen, bei denen die Lasereinrichtung 110 nicht gesondert hermetisch gekapselt ist.

Besonders bevorzugt ist das VCSEL-Array der Lasereinrichtung 110 dazu ausgebildet, Laserimpulse 24 mit einer Wellenlänge zu erzeugen, die in etwa den Absorptionswellenlängen von Bestandteilen des zu zündenden Luft-/Kraftstoffgemischs 22 (Figur 1) entspricht, wodurch eine effizientere Laserzündung auch bei geringeren Impulsenergien gegeben ist.

Beispielsweise kann ein Methan enthaltendes Gemisch effizient mittels Wellenlängen von etwa 1,33 µm (Mikrometer) und/oder etwa 1,65 µm gezündet werden.
Besonders bevorzugt kann die Lasereinrichtung 110 ferner Mittel 112 zur Phasenkopplung einzelner Halbleiterlaser des VCSEL-Arrays aufweisen. Beispielsweise ist ein oberflächenemittierender Halbleiterlaser der Lasereinrichtung 110 so ausgebildet, dass er zeitlich geringfügig vor den anderen oberflächenemittierenden Halbleiterlasern der Lasereinrichtung 110 angesteuert wird, und dass die von ihm erzeugte Laserstrahlung auf alle anderen oberflächenemittierenden Halbleiterlaser der Lasereinrichtung 110n eingestrahlt wird. Dadurch können sich die anderen oberflächenemittierenden Halbleiterlaser auf den Referenz-Laser, der auch als Seed-Laser bezeichnet wird, synchronisieren, wodurch eine maximale Kohärenz der von der Lasereinrichtung 110 abgegebenen Laserstrahlung 24 gewährleistet wird.

Eine konstruktiv besonders wenig aufwendige Erfindungsvariante sieht vor, dass die Mehrzahl von oberflächenemittierenden Halbleiterlasern der Lasereinrichtung 110 in einer im Wesentlichen ebenen Konfiguration angeordnet ist. Beispielsweise können die einzelnen Oberflächenemitter so angeordnet sein, dass sie bei ihrer Anordnung auf der Wärmesenke 104 wie in Figur 2 veranschaulicht die erzeugte Laserstrahlung direkt in Richtung des Brennraumfensters 26 abstrahlen.

Bei einer weiteren vorteilhaften Ausführungsform kann vorgesehen sein, dass mehrere Gruppen von oberflächenemittierenden Halbleiterlasern vorgesehen sind, und dass Mittel zur Überlagerung der von den einzelnen Gruppen (VCSEL-Arrays) erzeugten Laserstrahlung vorgesehen sind. Beispielsweise können in unterschiedlichen Raumrichtungen abstrahlende VCSEL-Arrays (nicht gezeigt) vorgesehen sein, deren Laserstrahlung über geeignete Spiegeleinrichtungen wie beispielsweise Stufenspiegel wiederum überlagert wird, um den Laserimpuls 24 zu bilden. Durch eine derartige, auch als Umstapeltechnik bezeichnete Anordnung können insbesondere auch Laser mit unterschiedlicher Wellenlänge und/oder Polarisation in die Lasereinrichtung 110 integriert werden, wodurch eine weitere Steigerung der Leistungsdichte bzw. der Impulsenergie möglich ist.

Figur 3 zeigt eine weitere Ausführungsform mit einer erfindungsgemäßen Lasereinrichtung 110, die zusätzlich über einen optischen Verstärker 120 verfügt. Der optische Verstärker 120 wird durch eine Pumplichtquelle 130 mit Pumplicht 60 beaufschlagt. Bei der Pumplichtquelle 130 kann es sich vorteilhaft ebenfalls um ein VCSEL-Array handeln.

Durch die in Figur 3 gezeigte Anordnung ergibt sich vorteilhaft ein longitudinales optisches Pumpen des optischen Verstärkers 120, so dass ein optimales Überlappen zwischen der Pumpstrahlung 60 und der zu verstärkenden Laserstrahlung 24 in dem optischen Verstärker 120 gegeben ist. Bevorzugt kann der optische Verstärker 120 an seiner in Figur 3 rechten Stirnseite hochreflektierend für die Pumpstrahlung 60 beschichtet sein, so dass die Pumpstrahlung 60 den optischen Verstärker 120 in Longitudinalrichtung mindestens zweimal durchläuft, um ein noch effizienteres optisches Pumpen zu ermöglichen.

Ebenfalls in Figur 3 angedeutet ist eine optionale weitere Pumplichtquelle 150, die dazu ausgebildet ist, den optischen Verstärker 120 transversal mit Pumplicht zu beaufschlagen. Eine Kombination von longitudinalem und transversalem optischen Pumpen ist ebenfalls möglich. Auch ein allein transversales Pumpen ist denkbar. Das transversale Pumpen ermöglicht prinzipiell den Einsatz längerer Verstärkerkristalle 120 und damit höhere Verstärkungsfaktoren.

Am Ausgang des optischen Verstärkers 120 wird ein verstärkter Laserimpuls 24' erhalten.

Die Einkopplung der von der Lasereinrichtung 110 erzeugten Laserstrahlung 24 in den optischen Verstärker 120 erfolgt vorliegend mittels einer Spiegeloptik 140, 142, wobei ein erster Spiegel 142 die Laserstrahlung 24 auf einen dichroitischen zweiten Spiegel 140 umlenkt, der die Laserstrahlung 24 schließlich in Longitudinalrichtung in den optischen Verstärker 120 ablenkt. Der dichroitische Spiegel 140 ist bevorzugt hochtransmittierend für die Wellenlänge der Pumpstrahlung 60.

Das erfindungsgemäße Prinzip unter Verwendung von VCSEL-Arrays, das heißt einer Vielzahl von oberflächenemittierenden Halbleiterlasern, zur Erzeugung der Laserimpulse 24 ermöglicht vorteilhaft, während eines einzigen Arbeitszyklus eines Zylinders 12 der Brennkraftmaschine 10 (Figur 1) mindestens einen Laserimpuls 24 mit einer Impulsdauer von 100 ns oder weniger, vorzugsweise von 20 ns oder weniger zu erzeugen. Besonders bevorzugt wird die Lasereinrichtung 110 mit einem Puls-Pausenverhältnis von kleiner etwa 1:100, vorzugsweise kleiner etwa 1:1000, betrieben, wodurch Untersuchungen der Anmelderin zufolge besonders hohe optische Ausgangsleistungen für die Lasereinrichtung 110 erzielbar sind, bei gleichzeitig geringer Erwärmung der Lasereinrichtung 110. Insbesondere kann die Lasereinrichtung 110 gegenüber herkömmlichen Ansteuerverfahren mit wesentlich höheren Strömen betrieben werden, wobei die Pulsdauern auch kürzer als 10 ns sein können.

Bei einer weiteren besonders bevorzugten Ausführungsform ist vorgesehen, dass innerhalb eines Arbeitszyklus mehrere Laserimpulse 24 mit einer maximalen Impulsdauer von je etwa 20 ns und einer minimalen Impulsenergie von je etwa 0,1 mJ erzeugt werden, wodurch eine besonders zuverlässige Entzündung des Luft-/Kraftstoffgemischs in dem Brennraum 14 (Figur 1) gewährleistet ist.

Wenn die Lasereinrichtung 110 der Laserzündkerze 100 durch eine entsprechende elektrische Ansteuerung (vergleiche Steuergerät 32 aus Figur 1) mit einem verhältnismäßig geringen Puls-Pausen-Verhältnis von kleiner gleich etwa 1:1000 betrieben wird, können besonders viele Laserimpulse 24 mit einer Impulsdauer im Bereich einiger 10 ns hintereinander mit ähnlicher Impulsenergie emittiert werden. Da sich das Luft-/Kraftstoffgemisch in dem Brennraum 14 während einer Mikrosekunde nicht wesentlich weiterbewegt, kann unter Verwendung des erfindungsgemäßen Betriebesverfahrens eine gegenüber herkömmlichen Laserzündverfahren gesteigerte Menge von Zündenergie in das Plasma eingebracht werden und so die Wahrscheinlichkeit für eine sichere Entzündung erhöht werden bzw. der Zündenergiebedarf pro einzelnem Laserimpuls 24 gesenkt werden.

Ein weiterer besonderer Vorteil der erfindungsgemäßen Konfiguration ist die Möglichkeit, den Zündzeitpunkt mit einer Präzision von wenigen Nanosekunden genau einzustellen, weil das VCSEL-Array 110 ein elektrisches Ansteuersignal nahezu verzögerungsfrei in einen Laserimpuls 24 umsetzt.

Bei der Ausführungsform gemäß Figur 3 kann der optische Verstärker 120 beispielsweise ein Yb (Ytterbium)-dotiertes Wirtsmaterial aufweisen, für das Pumplichtwellenlängen von 940 nm bzw. etwa 975 nm bis 980 nm und Pumpdauern von etwa < 1 ms (Millisekunde) sinnvoll sind. Nach einem derartigen Pumpvorgang wird der auch als Seed-Puls bezeichnete Laserimpuls 24 der Lasereinrichtung 110 über die Einkoppeloptik 140, 142 in den optischen Verstärker 120 eingekoppelt. Der als Seed-Puls fungierende Laserimpuls 24 sollte hierbei eine Wellenlänge in der Nähe eines Verstärkungsmaximums des optischen Verstärkermaterials 120 aufweisen. Für Yb-dotierte Materialien ist zum Beispiel eine Wellenlänge von 1030 nm sinnvoll. Der Seed-Puls 24 sollte bereits eine Mindestenergie von einigen 100 µJ (Mikrojoule) haben, um gut verstärkt werden zu können. Um eine möglichst effiziente optische Verstärkung zu ermöglichen, sollten die Pumpstrahlung 60 und die Seed-Strahlung 24 möglichst parallel und mit gleichem Strahldurchmesser durch den optischen Verstärker 120 geführt werden. In diesem Fall wird nämlich ein maximal effizienter Abbau der von dem Pumplaser 130 erzeugten Besetzungsinversion in dem optischen Verstärker 120 durch den Seed-Puls 24 ermöglicht.

Wie bereits vorstehend unter Bezugnahme auf Figur 2 beschrieben, kann der Seed-Laser, d.h. die Lasereinrichtung 110, vorteilhaft phasengekoppelt realisiert sein, um eine möglichst kohärente Laserstrahlung 24 zu erhalten. Dadurch sind höhere Intensitäten an dem Zündpunkt im Brennraum 14 erreichbar.

Als Material für den optischen Verstärker 120 ist z.B. Yb:YAG (Ytterbiumdotierter Yttrium-Aluminium-Granat) aufgrund seiner hohen Fluoreszenzlebensdauer und den für den Halbleiterlaser 110 besonders geeigneten Absorptionswellenlängen vorteilhaft. Aber auch andere Yb-dotierte Materialien (insbesondere Granate und Sesquioxide) sind geeignet.

## Patentansprüche

1. Laserzündkerze (100) für eine Brennkraftmaschine (10), mit einer Lasereinrichtung (110) zur Erzeugung von Laserimpulsen (24), **dadurch gekennzeichnet, dass** die Lasereinrichtung (110) eine Mehrzahl von oberflächenemittierenden Halbleiterlasern zur Erzeugung der Laserimpulse (24) aufweist und die Lasereinrichtung (110) in die Laserzündkerze (100) integriert ist und dass die Lasereinrichtung (110) hermetisch gekapselt ist und dass eine im Strahlengang angeordnete Fokussieroptik (26) zur Einkopplung der von den oberflächenemittierenden Halbleiterlasern erzeugten Laserstrahlung in den Brennraum der Brennkraftmaschine (10) vorgesehen ist.

2. Laserzündkerze (100) nach Anspruch 1, **dadurch gekennzeichnet, dass** die Lasereinrichtung (110) dazu ausgebildet ist, Laserimpulse (24) mit einer Wellenlänge von etwa 400 Nanometer bis etwa 2500 Nanometer zu erzeugen.

3. Laserzündkerze (100) nach einem der vorstehenden Ansprüche, **dadurch gekennzeichnet, dass** die Lasereinrichtung (110) Mittel (112) zur Phasenkopplung einzelner Halbleiterlaser aufweist.

4. Laserzündkerze (100) nach einem der vorstehenden Ansprüche, **dadurch gekennzeichnet, dass** eine Mehrzahl von oberflächenemittierenden Halbleiterlasern der Lasereinrichtung (110) in einer im wesentlichen ebenen Konfiguration angeordnet ist.

5. Laserzündkerze (100) nach einem der vorstehenden Ansprüche, **dadurch gekennzeichnet, dass** mehrere Gruppen von oberflächenemittierenden Halbleiterlasern vorgesehen sind, und dass Mittel zur Überlagerung der von den einzelnen Gruppen erzeugten Laserstrahlung vorgesehen sind.

6. Laserzündkerze (100) nach Anspruch 5, **dadurch gekennzeichnet, dass** die Mittel zur Überlagerung mindestens ein dichroitisches Element und/oder ein polarisationsabhängiges Element aufweisen.

7. Laserzündkerze (100) nach einem der vorstehenden Ansprüche, **dadurch gekennzeichnet, dass** ein optischer Verstärker (120) zur optischen Verstärkung der von der Lasereinrichtung (110) erzeugten Laserimpulse (24) vorgesehen ist, und dass eine Pumplichtquelle (130) zum optischen Pumpen des optischen Verstärkers (120) vorgesehen ist.

8. Laserzündkerze (100) nach Anspruch 7, **dadurch gekennzeichnet, dass** die Pumplichtquelle (130) mindestens einen Halbleiterlaser aufweist.

9. Laserzündkerze (100) nach Anspruch 7 oder 8, **dadurch gekennzeichnet, dass** die Pumplichtquelle (130) in die Laserzündkerze (100) integriert ist, und dass eine Einkoppeloptik (140, 142) vorgesehen ist, um die Laserimpulse (24) der Lasereinrichtung (110) und von der Pumplichtquelle (130) erzeugte Pumpstrahlung (60) longitudinal in den optischen Verstärker (120) einzukoppeln.

10. Laserzündkerze (100) nach einem der Ansprüche 7 bis 9, **dadurch gekennzeichnet, dass** die Lasereinrichtung (110) und die Pumplichtquelle (130) auf einer gemeinsamen Wärmesenke (104) angeordnet sind.

11. Verfahren zum Betreiben einer Laserzündkerze (100) nach einem der vorangehenden Ansprüche **dadurch gekennzeichnet, dass** die Lasereinrichtung (110) innerhalb eines Arbeitszyklus eines Zylinders (12) der Brennkraftmaschine (10) mindestens einen Laserimpuls (24) mit einer Impulsdauer von 100 Nanosekunden oder weniger erzeugt.

12. Verfahren nach Anspruch 11, **dadurch gekennzeichnet, dass** die Lasereinrichtung (110) mit einem Puls-Pausenverhältnis von kleiner etwa 1 zu 100 betrieben wird.

13. Verfahren nach Anspruch 12, **dadurch gekennzeichnet, dass** innerhalb eines Arbeitszyklus mehrere Laserimpulse (24) mit einer maximalen Impulsdauer von je etwa 20 Nanosekunden und einer minimalen Impulsenergie von je etwa 0,1 Millijoule erzeugt werden.

14. Verfahren nach einem der Ansprüche 11 bis 13, **dadurch gekennzeichnet, dass** die Mehrzahl von oberflächenemittierenden Halbleiterlasern der Lasereinrichtung (110) phasengekoppelt betrieben wird.

## Claims

1. Laser spark plug (100) for an internal combustion engine (10), comprising a laser device (110) for generating laser pulses (24), **characterized in that** the laser device (110) comprises a plurality of surface emitting semiconductor lasers for generating the laser pulses (24) and the laser device (110) is integrated into the laser spark plug (100), and **in that** the laser device (110) is hermetically encapsulated, and **in that** provision is made of a focusing optical unit (26) arranged in the beam path and serving for coupling the laser radiation generated by the surface emitting semiconductor lasers into the combustion chamber of the internal combustion engine (10).

2. Laser spark plug (100) according to Claim 1, **characterized in that** the laser device (110) is configured to generate laser pulses (24) having a wavelength of approximately 400 nanometres to approximately 2500 nanometres.

3. Laser spark plug (100) according to either of the preceding claims, **characterized in that** the laser device (110) comprises means (112) for the phase locking of individual semiconductor lasers.

4. Laser spark plug (100) according to any of the preceding claims, **characterized in that** a plurality of surface emitting semiconductor lasers of the laser device (110) are arranged in a substantially planar configuration.

5. Laser spark plug (100) according to any of the preceding claims, **characterized in that** a plurality of groups of surface emitting semiconductor lasers are provided, and **in that** means for superimposing the laser radiation generated by the individual groups are provided.

6. Laser spark plug (100) according to Claim 5, **characterized in that** the superimposing means comprise at least one dichroic element and/or one polarization-dependent element.

7. Laser spark plug (100) according to any of the preceding claims, **characterized in that** provision is made of an optical amplifier (120) for optically amplifying the laser pulses (24) generated by the laser device (110), and **in that** provision is made of a pump light source (130) for optically pumping the optical amplifier (120).

8. Laser spark plug (100) according to Claim 7, **characterized in that** the pump light source (130) comprises at least one semiconductor laser.

9. Laser spark plug (100) according to Claim 7 or 8, **characterized in that** the pump light source (130) is integrated into the laser park plug (100), and **in that** a coupling-in optical unit (140, 142) is provided in order to couple the laser pluses (24) of the laser device (110) and pump radiation (60) generated by the pump light source (130) longitudinally into the optical amplifier (120).

10. Laser spark plug (100) according to any of Claims 7 to 9, **characterized in that** the laser device (110) and the pump light source (130) are arranged on a common heat sink (104).

11. Method for operating a laser spark plug (100) according to any of the preceding claims, **characterized in that** the laser device (110) generates at least one laser pulse (24) having a pulse duration of 100 nanoseconds or less within an operating cycle of a cylinder (12) of the internal combustion engine (10) .

12. Method according to Claim 11, **characterized in that** the laser device (110) is operated with a mark-space ratio of less than approximately 1 to 100.

13. Method according to Claim 12, **characterized in that** a plurality of laser pluses (24) having a maximum pulse duration of approximately 20 nanoseconds in each case and a minimum pulse energy of approximately 0.1 millijoule are generated within an operating cycle.

14. Method according to any of Claims 11 to 13, **characterized in that** the plurality of surface emitting semiconductor lasers of the laser device (110) are operated in a phase-locked manner.

## Revendications

1. Bougie d'allumage à laser (100) pour un moteur à combustion interne (10), comprenant un dispositif à laser (110) destiné à générer des impulsions laser (24), **caractérisée en ce que** le dispositif à laser (110) possède une pluralité de lasers en semiconducteur à émission par la surface destinés à générer les impulsions laser (24) et le dispositif à laser (110) est intégré dans la bougie d'allumage à laser (100) et **en ce que** le dispositif à laser (110) est encapsulé hermétiquement et **en ce qu'**une optique de concentration (26) disposée dans le trajet du rayon est présente pour l'injection du rayonnement laser généré par le laser en semiconducteur à émission par la surface dans la chambre de combustion du moteur à combustion interne (10) .

2. Bougie d'allumage à laser (100) selon la revendication 1, **caractérisée en ce que** le dispositif à laser (110) est configuré pour générer des impulsions laser (24) ayant une longueur d'onde d'environ 400 nanomètres à environ 2500 nanomètres.

3. Bougie d'allumage à laser (100) selon l'une des revendications précédentes, **caractérisée en ce que** le dispositif à laser (110) possède des moyens (112) servant au verrouillage de phase des lasers en semiconducteur individuels.

4. Bougie d'allumage à laser (100) selon l'une des revendications précédentes, **caractérisée en ce qu'**une pluralité de lasers en semiconducteur à émission par la surface du dispositif à laser (110) sont disposés dans une configuration sensiblement plane.

5. Bougie d'allumage à laser (100) selon l'une des revendications précédentes, **caractérisée en ce que** plusieurs groupes de lasers en semiconducteur à émission par la surface sont présents, et **en ce qu'**il existe des moyens destinés à la superposition du rayonnement laser généré par les groupes individuels.

6. Bougie d'allumage à laser (100) selon la revendication 5, **caractérisée en ce que** les moyens de superposition possèdent au moins un élément dichroïque et/ou un élément dépendant de la polarisation.

7. Bougie d'allumage à laser (100) selon l'une des revendications précédentes, **caractérisée en ce qu'**il existe un amplificateur optique (120) destiné à l'amplification optique des impulsions laser (24) générées par le dispositif à laser (110) et **en ce qu'**il existe une source de lumière de pompage (130) servant au pompage optique de l'amplificateur optique (120).

8. Bougie d'allumage à laser (100) selon la revendication 7, **caractérisée en ce que** la source de lumière de pompage (130) possède au moins un laser en semiconducteur.

9. Bougie d'allumage à laser (100) selon la revendication 7 ou 8, **caractérisée en ce que** la source de lumière de pompage (130) est intégrée dans la bougie d'allumage à laser (100), et **en ce qu'**il existe une optique d'injection (140, 142) pour injecter longitudinalement dans l'amplificateur optique (120) les impulsions laser (24) du dispositif à laser (110) ainsi que le rayonnement de pompage (60) généré par la source de lumière de pompage (130).

10. Bougie d'allumage à laser (100) selon l'une des revendications 7 à 9, **caractérisée en ce que** le dispositif à laser (110) et la source de lumière de pompage (130) sont disposés sur un dissipateur thermique (104) commun.

11. Procédé pour faire fonctionner une bougie d'allumage à laser (100) selon l'une des revendications précédentes, **caractérisé en ce que** le dispositif à laser (110) génère au moins une impulsion laser (24) ayant une durée d'impulsion de 100 nanosecondes au moins au sein d'un cycle de travail d'un cylindre (12) du moteur à combustion interne (10).

12. Procédé selon la revendication 11, **caractérisé en ce que** le dispositif à laser (110) fonctionne avec un rapport impulsion/pause inférieur à environ 1/100.

13. Procédé selon la revendication 12, **caractérisé en ce qu'**au sein d'un cycle de travail sont générées plusieurs impulsions laser (24) ayant une durée d'impulsion maximale d'environ 20 nanosecondes chacune et une énergie d'impulsion minimale d'environ 0,1 millijoule chacune.

14. Procédé selon l'une des revendications 11 à 13, **caractérisé en ce que** la pluralité de lasers en semiconducteur à émission par la surface du dispositif à laser (110) fonctionnent avec verrouillage de phase.
